# EUROPEAN PATENT APPLICATION

(11) **EP 2 546 875 A2**
(43) Date of publication of application: **16.01.2013**
(21) Application number: 12167154.9
(22) Date of filing: 08.05.2012
(51) Int. Cl.: H01L 25/075, H01L 33/50

(54) **Light-emitting device and illumination fixture using the same**

(30) Priority: 16.06.2011 JP 2011134342
(71) Applicant: Panasonic Corporation, Osaka 571-8501 (JP)
(72) Inventor: Takei, Naoko, Osaka, Osaka (JP); Nishioka, Kouji, Kurayosi, Tottori (JP)
(74) Representative: Rüger, Barthelt & Abel

(57) **Abstract**

[Object] To provide a uniform irradiation pattern in a light-emitting device having a plurality of solid light-emitting elements mounted on a board.

[Means for Settlement] A light-emitting device (1) includes: a plurality of solid light-emitting elements (2); a board (3) on which they are mounted; and a wavelength conversion part (4) coating them. The plurality of solid light-emitting elements (2) include: inner LEDs 21 arranged closely to a center of the board (3); and outer LEDs (22) arranged more closely to outer periphery than the inner LEDs (21). The wavelength conversion part (4) includes phosphors (5) and is composed of: a first wavelength conversion part (41) coating outer peripheral side surfaces of the outer LEDs (22); and a second wavelength conversion part (42) coating other portions. Concentration of the phosphors (5) of the first wavelength conversion part (41) is smaller than that of the phosphors (5) at the other portions.

Therefore, towards the outer periphery, light emanated from the outer LED (22) is hardly subjected to wavelength conversion, and light emanated from the inner LED (21) is likely to be subjected to the wavelength conversion. These emanated rays of light are irradiated in combination, thus hardly causing color unevenness, which can provide a uniform irradiation pattern.

## Description

### [Technical Field]

The present invention relates to a light-emitting device having a plurality of solid light-emitting elements mounted on a board and an illumination fixture using the same.

### [Background Art]

Conventionally, light sources such as incandescent lamps, fluorescent lamps, and high pressure discharge lamps have been used as illumination fixtures. In recent years, LED (light-emitting diode) illumination light sources have been widespread in terms of low power consumption and long life. Since one LED element provides a small luminous flux, the LED illumination light source uses a plurality of LED elements for the purpose of obtaining the same level of luminous flux as that of the conventional light sources. To achieve an LED illumination light source with high output, the LED elements tend to be mounted onto a board in higher density.

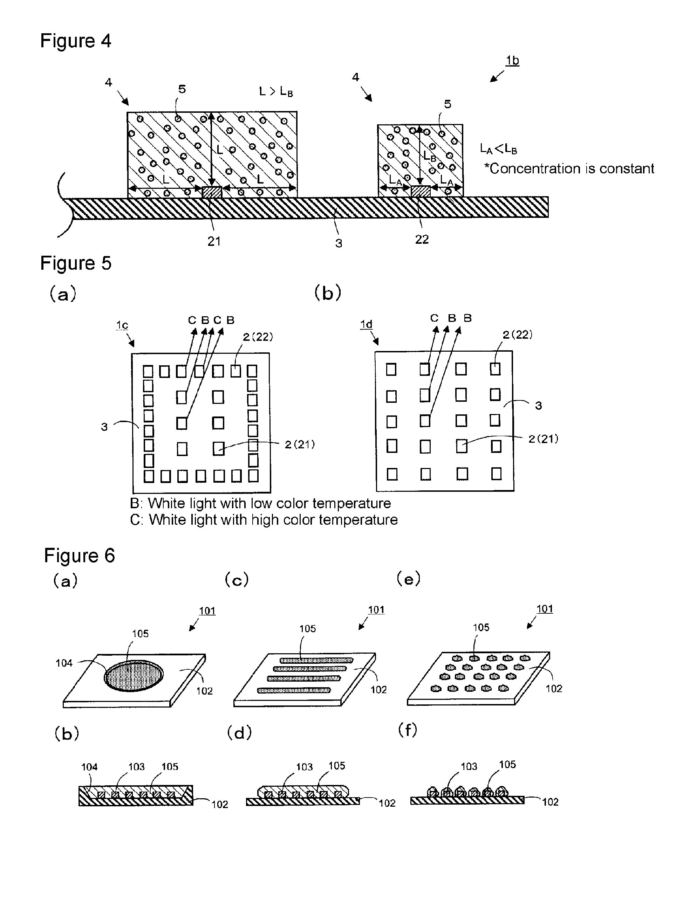

Used as an LED illumination light source of this type is a white LED light source that, by coating a blue-light emanating LED element on a board with a resin layer containing phosphors which convert blue light into yellow light, mixes the blue light and the yellow light to generate white light. As phosphor arrangement configuration of such an LED board, various arrangements have been suggested because their fabrication is easy and an amount of phosphors used is small. Figs. 6(a) to 6(f) show arrangement examples of such a phosphor layer.

An LED illumination light source 101 as shown in Figs. 6 (a) and 6 (b) has a plurality of LED elements 103 mounted on a concave portion 104 of a circular shape formed on a board 102 and has a phosphor layer 105 provided in the concave portion 104. Moreover, an LED illumination light source 101 shown in Figs. 6 (c) and 6 (d) has phosphor layers 105 applied in a line form onto a plurality of LED elements 103. Moreover, an LED illumination light source 101 shown in Figs. 6 (e) and 6 (f) has each of phosphor layers 105 potted to each of LED elements 103.

### [Conventional Technique Document]

### [Patent Literature]

[Patent Literature 1] JPA 2011-60967

### [Disclosure of the Invention]

### [Problems to be solved by the Invention]

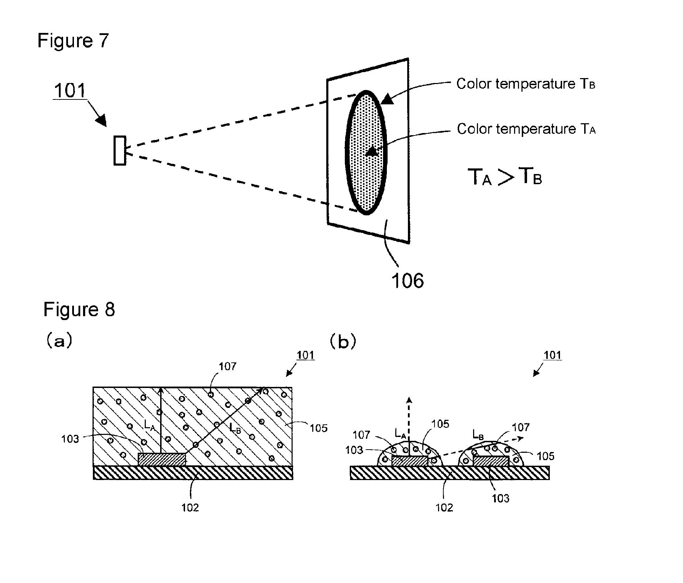

Fig. 7 shows an example of an irradiation pattern of an LED illumination light source with the configuration as described above. For an irradiation pattern of irradiation from the LED illumination light source 101 to an irradiated surface 106, color temperature T_{A} of light at a central portion may become higher than color temperature T_{B} of light at a peripheral edge portion, and also the color temperature may become increasingly smaller from the central portion to the peripheral edge portion. A reason for this will be described referring to Figs. 8 (a) and 8 (b). An LED illumination light source 101 shown in Fig. 8 (a) has a phosphor layer 105 formed on a board 102 on which a solid light-emitting element 103 is mounted. Moreover, the LED illumination light source 101 shown in Fig. 8 (b) has the phosphor layers 105 potted to two adjacent solid light-emitting elements 103 on the board 102. As shown in Fig. 8 (a), when light emanated from the LED element 103 is blue light, light emanated vertically to a mounted surface of the board 102 and light emanated obliquely thereto travel through the phosphor layer 105 over different distances. That is, the travel distance L_{B} of the obliquely emanated light is longer than the travel distance L_{A} of the vertically emanated light, and thus a larger ratio of the obliquely emanated light is irradiated to a phosphor 107 to be subjected to wavelength conversion than a ratio of the vertically emanated light. Therefore, this obliquely emanated light has a larger amount of yellow light components obtained through the wavelength conversion than that of blue light components, and thus becomes light with low color temperature, which is consequently likely to cause color unevenness.

Moreover, as shown in Fig. 8 (b), light emanated obliquely from one of the adjacent LED elements 103 travels through the phosphor layer 105 coating this LED element 103 and the phosphor layer 105 coating the other LED element 103. Especially in a light-emitting device having a high density of a plurality of LED elements, such travel is likely to occur. Thus, also in potting, the travel distance L_{B} of the obliquely emanated light is longer than the travel distance L_{A} of the vertically emanated light, causing the same phenomena as that described above.

Thus, to suppress the color unevenness, there is an illumination device which has a plurality of LED elements and which has a V-shaped groove portion formed on front surfaces of phosphor layers along end surfaces of the LED elements (for example, see Patent Literature 1). In this illumination device, compared to the case where no V-shaped groove portion is formed, travel distance of obliquely emanated light is smaller, and thus the travel distance of obliquely emanated light is equal to travel distance of vertically emanated light.

However, also in the LED illumination light source as shown in Patent Literature 1, light from one of the LED elements may travel through the phosphor layer coating one of the LED element and the phosphor layer coating another LED element, and it is assumed that the same phenomenon as that in the aforementioned potting occurs.

The present invention has been made to solve the problem described above, and it is an object of the present invention to provide a light-emitting device capable of providing a uniform irradiation pattern in an illumination light source having high density of a plurality of solid light-emitting elements mounted on a board and also provide an illumination fixture using the same.

### [Means adapted to solve the Problems]

A light-emitting device according to the present invention includes: a plurality of solid light-emitting elements mounted on a board; and a wavelength conversion part coating the solid light-emitting elements and including phosphors, wherein the plurality of solid light-emitting elements include: solid light-emitting elements arranged at position close to a center of the board; and solid light-emitting elements arranged at position close to outer periphery than the aforementioned solid light-emitting elements, and the wavelength conversion part is configured such that concentration of the phosphors at a portion coating the solid light-emitting elements arranged at the position close to the outer periphery of the board is lower than concentration of the phosphors at other portions.

In this light-emitting device, the wavelength conversion part is preferably configured such that concentration of the phosphors at the portion coating the solid light-emitting elements arranged at the position close to the outer periphery of the board is lower than concentration of the phosphors at the other portions.

In this light-emitting device, the wavelength conversion part is preferably configured such that concentration of the phosphors at a portion coating outer peripheral side surfaces of the solid light-emitting elements arranged at the position close to the outer periphery of the board is lower than the concentration of the phosphors at the other portions.

In this light-emitting device, the wavelength conversion part is preferably configured such that thickness of the portion coating the solid light-emitting elements arranged at the position close to the outer periphery of the board is thinner than thickness of the other portions.

In this light-emitting device, the wavelength conversion part is preferably configured such that thickness of the portion coating the outer peripheral side surfaces of the solid light-emitting elements arranged at the position close to the outer periphery of the board is thinner than the thickness of the other portions.

In this light-emitting device, an arrangement interval between the solid light-emitting elements arranged at the position close to the outer periphery of the board is preferably smaller than an arrangement interval between the solid light-emitting elements arranged at the position close to the center.

This light-emitting device is preferably used for an illumination fixture.

### [Effect of the Invention]

With the light-emitting device according to the present invention, light emanated from the solid light-emitting element arranged at the position close to the outer periphery of the board towards the outer periphery has low proportion of the phosphors of the wavelength conversion part and thus is hardly subjected to wavelength conversion. Moreover, light emanated from the solid light-emitting element arranged at the position close to the center of the board towards the outer periphery has high proportion of the phosphors of the wavelength conversion part and thus is likely to be subjected to wavelength conversion. As a result, towards the outer periphery of the board, these emanated rays of light are irradiated in combination, thus hardly causing color unevenness, which can provide uniform irradiation patters.

### [Brief Description of the Drawings]

[Fig. 1] Fig. 1 (a) is a perspective view of a light-emitting device according to a first embodiment of the present invention, Fig. 1 (b) is a sectional view thereof, and Fig. 1(c) is a partially enlarged sectional view thereof.
[Fig. 2] Fig. 2 is a sectional view illustrating operation of the same light-emitting device.
[Fig. 3] Fig. 3 is a sectional view of a light-emitting device according to a second embodiment.
[Fig. 4] Fig. 4 is a sectional view of a light-emitting device according to a third embodiment.
[Fig. 5] Fig. 5 (a) is a top view of a light-emitting device according to a fourth embodiment and Fig. 5 (b) is a top view of a light-emitting device as a reference example of Fig. 5 (a) in which a plurality of solid light-emitting elements is arranged at equal intervals.
[Fig. 6] Figs. 6 (a) through 6(f) are perspective views and sectional views of a conventional LED illumination light source.
[Fig. 7] Fig. 7 is a perspective view illustrating an irradiation pattern of the LED illumination light source.
[Fig. 8] Figs. 8 (a) and 8 (b) are sectional views illustrating light paths in the same LED illumination light source.

### [Best Modes for Carrying out the Invention]

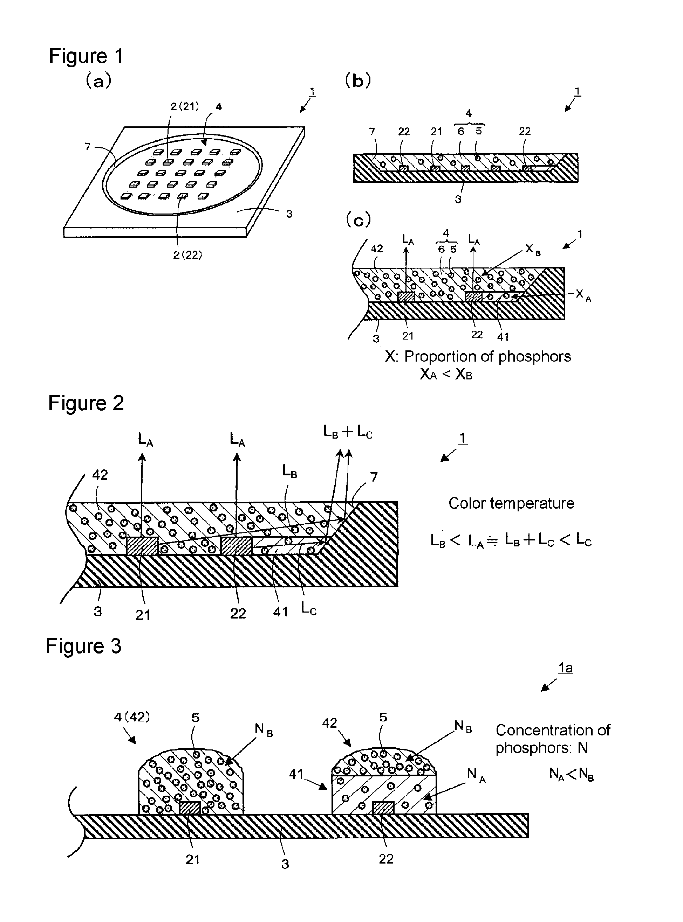

Hereinafter, a light-emitting device according to a first embodiment of the present invention will be described referring to Fig. 1. The light-emitting device 1 includes: a plurality of solid light-emitting elements 2; a board 3 on which the solid light-emitting elements 2 are mounted; and a wavelength conversion part 4 that coats the solid light-emitting elements 2. Illustrated in the figure is an example in which the solid light-emitting elements 2 are arranged in a matrix form of 5 rows and 5 columns, although the arrangement is not limited thereto. The wavelength conversion part 4 includes: for example, phosphors 5 such as yellow phosphors that subject blue light emanated from a blue LED to wavelength conversion; and a binder 6 that holds this phosphors 5.

Formed on a front surface of the board 3 is a concave portion 7 of a circular shape, and on a bottom surface of this concave portion 7, a wiring pattern (not shown) is formed. The plurality of solid light-emitting elements 2 have an electrode part (not shown) electrically connected to the wiring pattern to be thereby mounted onto a bottom part of the concave portion 7.

The plurality of solid light-emitting elements 2 include: solid light-emitting elements 21 (hereinafter referred to inner LEDs) arranged at position close to a center of the board 3; and solid light-emitting elements 22 (hereinafter referred to as outer LEDs) arranged at position closer to outer periphery than the solid light-emitting elements 21. In the present embodiment, for example, the inner LEDs 21 denote the solid light-emitting elements which are arranged at the position close the center of the board 3 and which have their periphery surrounded by the other solid light-emitting elements, and the outer LEDs 22 denote the solid light-emitting elements which have their outer periphery not close to any of the solid light-emitting elements. "The position close to the center" or "the position closer to the outer periphery" mentioned here refer to not absolute positional relationship with respect to the board 3 but relative positional relationship between the plurality of solid light-emitting elements 2. Therefore, for example, in the case where the board 3 is large for a mounting area on which the solid light-emitting elements 2 are mounted, it is possible that "the solid light-emitting elements arranged at the position closer to the outer periphery" are separated from an outer peripheral edge of the board 3 and they are arranged closely to the center of the entire board 3.

According to the illustrated example, the inner LEDs 21 are arranged in a grid form of 3 rows and 3 columns on the bottom surface of the concave portion 7. Moreover, the outer LEDs 22 are arranged in a frame-like form in such a manner as to surround these inner LEDs 21. In this arrangement, light emanated from the inner LED 21 towards the outer periphery of the board 3, compared to light emanated from the outer LED 22, travels through the wavelength conversion part 4 over longer distance and is more likely to be subjected to the wavelength-conversion by the phosphors 5, thus has a large amount of yellow light components, and is more likely to become white light with low color temperature. Moreover, a larger number of rays of the light emanated from the inner LED 21 towards the outer periphery of the board 3, compared to rays of the light emanated from the outer LED 22, are superposed on each other, thus largely influencing a light color of light irradiated towards outer periphery of the light-emitting device 1.

Used as the solid light-emitting element 2 can be a light-emitting diode that emits light containing a wavelength in any band of blue light (with a peak wavelength of 430 nm to 470 nm). Moreover, instead of the light-emitting diode, for example, an organic electroluminescence (OLED) can be used. For the solid light-emitting element 2, for example, an optical control member or the like that can distribute emanated light in a wide range may be used.

Used as the board 3 can be a planar board formed from, for example, ceramic or glass epoxy. On an inner surface and the bottom surface of the concave portion 7, a reflective member made of a material, for example, silver or aluminum, having a high reflection rate may be used. This permits effective diffusion of the light emanated from the solid light-emitting element 2. Moreover, the arrangement of the plurality of solid light-emitting elements 2 is not limited to the matrix form but may be, for example, a line form or a staggered shape. The arrangement in the line form simplifies processes of mounting the solid light-emitting elements 2 and the arrangement in the staggered shape permits effective release of heat of the solid light-emitting elements 2. Moreover, a smaller interval at which the adjacent solid light-emitting elements 2 are arranged can provide higher emission efficiency, but it is appropriately set in view of heat dissipation performance.

The wavelength conversion part 4 is filled in the concave portion 7 of the board 3 to coat the inner LEDs 21 and the outer LEDs 22. In this example, a portion of the wavelength conversion part 4 coating outer peripheral side surfaces of the outer LEDs 22 is referred to as a first wavelength conversion part 41 and other portions are referred to as a second wavelength conversion part 42. Moreover, the wavelength conversion part 4 is configured such that proportion X of the phosphors 5 at the portion coating the outer LEDs 22 (probability of hitting the phosphors by light travelling through the wavelength conversion part) is lower than proportion X of the phosphors 5 at the other portions. In the present embodiment, the first wavelength conversion part 41 and the second wavelength conversion part 42 are configured such that proportion X_{A} of the phosphors 5 of the first wavelength conversion part 41 is smaller than proportion X_{B} of the phosphors 5 of the second wavelength conversion part 42. That is, the light travelling through inside of the first wavelength conversion part 41 towards the outer periphery of the board 3, compared to light travelling through inside of the second wavelength conversion part 42, hits the phosphors 5 to be subjected to the wavelength conversion in a smaller ratio, has a large amount of blue light components, and thus becomes white light with high color temperature. Moreover, the light travelling through the inside of the second wavelength conversion part 42 towards the outer periphery of the board 3, compared to the light travelling through the inside of the first wavelength conversion part 41, is subjected to the wavelength conversion in a greater ratio, has a large amount of yellow light components, and thus becomes white light with low color temperature.

The phosphors 5 are diffused in the binder 6, and subject blue light guided to the binder 6 to wavelength conversion into light having an emission peak in a green light region to a red light region on a long-wavelength side. To provide white light, a yellow phosphor is preferably used, and to provide white light with high color rendering properties, a green phosphor and a red phosphor are appropriately combined together for use.

The binder 6 is a main component of the wavelength conversion part 4. Into this binder 6, a diffusing material may be mixed when needed. This can effectively diffuse light emanated from the solid light-emitting element 2 in the binder 6. Used as the diffusing material can be an inorganic material such as aluminum oxide or silica or a material which is formed from an organic material such as fluorine-based resin and which has an average particle diameter of 1 µm. The binder 6 is formed, for example, along an array of the solid light-emitting elements 2, into a line form on the solid light-emitting elements 2 or potted onto each of the solid light-emitting elements 2 to be formed into a predetermined shape.

From the inner LEDs 21 and the outer LEDs 22, light is emanated radially with respect to, as a center, light L_{A} emanated vertically to a mounting surface of the board 3, and the luminous flux of the vertically emanated light L_{A} is usually largest. Then the light L_{A} is transmitted through the second wavelength conversion part 42 and is subjected to wavelength-conversion, turning into main light irradiated from the light-emitting device 1. Thus, in the present embodiment, concentration and thickness of the phosphors 5 of the second wavelength conversion part 42 and a combination ratio of a plurality of kinds thereof, if combined, are appropriately adjusted so that the vertically emanated light L_{A} becomes white light with desired color temperature.

Moreover, in the present embodiment, proportion X_{A} of the phosphors 5 of the first wavelength conversion part 41 smaller than that of the second wavelength conversion part 42 is set by adjusting the concentration of the phosphors 5. More specifically, to provide small proportion X_{A} of the phosphors 5 in the first wavelength conversion part 41, the concentration of the phosphors 5 of the first wavelength conversion part 41 is smaller than the concentration of the phosphors 5 of the second wavelength conversion part 42. This can, without changing the shape of the first wavelength conversion part 41, provide lower proportion X_{A} of the phosphors 5 of the first wavelength conversion part 41 than that of any other portion. This configuration is preferably used in the case where a space in which the first wavelength conversion part 41 is formed is limited.

Listed as methods of providing small proportion X_{A} of the phosphors 5 are: in addition to a method of adjusting the concentration of the phosphors 5 as described above, a method of adjusting thickness of the wavelength conversion part 4, more specifically, a method of making the thickness of the first wavelength conversion part 41 thinner than that of the second wavelength conversion part 42. With this method, an absolute amount of the phosphors 5 of the first wavelength conversion part 41 for the outer periphery of the board 3 is smaller than that of the second wavelength conversion part 42, which can therefore provide lower proportion X_{A} of the phosphors 5 of the first wavelength conversion part 41 than that of any other portion. The aforementioned method is preferably used in the case where the space in which the first wavelength conversion part 41 is formed is not limited.

Next, operation of the light-emitting device 1 will be described referring to Fig. 2. The light L_{A} emanated vertically from the inner LED 21 and the outer LED 22 to the mounting surface of the board 3 is irradiated as white light with desired color temperature because the second wavelength conversion part 42 is configured as described above.

Light L_{B} emanated from the inner LED 21 towards the outer periphery of the board 3 travels obliquely through the second wavelength conversion part 42 and is reflected on the inner surface of the concave portion 7. At this point, this emanated light L_{B} travels in longer distance than light L_{C} emanated from the outer LED 22 towards the outer periphery, is subjected to the wavelength conversion by the phosphors 5 in a larger ratio, thus has a large amount of blue light components, and becomes white light with low color temperature.

The light L_{C} emanated from the outer LED 22 towards the outer periphery of the board 3 travels through the first wavelength conversion part 41 and is reflected on the inner surface of the concave portion 7. At this point, this emanated light L_{C} travels over shorter distance than the light L_{B} emanated from the inner LED 21 towards the outer periphery, is subjected to the wavelength conversion by the phosphors 5 in a smaller ratio, thus has a large amount of blue light components, and becomes white light with high color temperature.

The aforementioned white light L_{B} with the low color temperature and the white light L_{C} with the high color temperature are mixed and then guided to outside of the light-emitting device 1 with color temperature substantially equal to that of the white light L_{A} which is not biased to either of the color temperatures.

With the light-emitting device 1 of the present embodiment, the light L_{B} emanated from the outer LED 22 is hardly subjected to wavelength conversion by the first wavelength conversion part 41, and the light L_{C} emanated from the inner LED 21 towards the outer periphery of the board 3 is more likely to be subjected to wavelength conversion by the second wavelength conversion part 42 than the light L_{B} emanated from the outer LED 22. Towards the outer periphery of the board 3, the emanated light L_{B} and L_{C} are irradiated in combination and color temperature of this irradiated light L_{B}+L_{C} is not largely different from color temperature of light emanated in a different direction (mainly white light L_{A}), thus hardly causing color unevenness, which can provide a uniform irradiation pattern. Moreover, using such a light-emitting device 1 as an illumination fixture permits irradiation of light with a uniform irradiation pattern.

Next, a light-emitting device according to a second embodiment will be described referring to Fig. 3. The light-emitting device 1a not has a plurality of solid light-emitting elements 2 (21 and 22) collectively coated with one wavelength conversion part 4 but has the solid light-emitting elements 2 each coated with the wavelength conversion part 4. Each wavelength conversion part 4 is formed by potting. Moreover, concentration of phosphors 5 of the wavelength conversion part 4 coating the outer LED 22 is lower than concentration of other portions. More specifically, a first wavelength conversion part 41 whose concentration of the phosphors 5 is N_{A} coats the outer LED 22, and a second wavelength conversion part 42 whose concentration of the phosphors 5 is N_{B} (N_{A} < N_{B}) coats top of the first wavelength conversion part 41 and the inner LED 21. Other configuration is the same as that of the first embodiment. Illustrated in the figure are only the outer LED 22 on the board 3, the inner LED 21 located adjacently thereto in a direction towards inner periphery, and the wavelength conversion parts 4 coating them.

With this configuration, light emanated towards outer periphery of the inner LED 22 is hardly subjected to wavelength conversion by the phosphors 5 because concentration of the phosphors 5 of the first wavelength conversion part 41 is lower than that of the wavelength conversion part 4 coating the inner LED 21, thus has a large amount of blue light components, and becomes white light with high color temperature. Moreover, light emanated towards outer periphery of the inner LED 21 located inside travels through the wavelength conversion part 4 of the outer LED 22 located further outside and has higher concentration of the phosphors 5 of the second wavelength conversion part 42 located inside than that of the first wavelength conversion part 41, is thus easily subjected to wavelength conversion, has a large amount of yellow light components, and becomes white light with low color temperature. Then these white rays of light are combined together and irradiated to outside of the light-emitting device 1a. Therefore, also in the present embodiment, as is the case with the first embodiment, color unevenness hardly occurs and a uniform irradiation pattern can be provided.

Next, a light-emitting device according to a third embodiment will be described referring to Fig. 4. In the light-emitting device 1b according to the present embodiment, thickness of a portion coating an outer LED 22 is smaller than thickness of any other portion. In this example, the horizontal thickness of the outer LED 22 is L_{A} and the vertical thickness is L_{B} (>L_{A}), and the horizontal and vertical thickness of the inner LED 21 is L (>L_{B}). Concentration of phosphors 5 of wavelength conversion parts 4 coating the inner LED 21 and the outer LED 22 is constant. That is, in the present embodiment, proportion X of the aforementioned phosphors 5 is set by adjusting thickness of the wavelength conversion parts 4. Other configuration is the same as that of the second embodiment.

With this configuration, light emanated towards outer periphery of the outer LED 22 travels over shorter distance than that of the inner LED 21 and is hardly subjected to wavelength conversion by the phosphors 5, thus has a large amount of blue light components, and becomes white light with high color temperature. Moreover, the light emanated toward outer periphery of the inner LED 21 travels over longer distance than that of the outer LED 22 and travels through the wavelength conversion part 4 coating the outer LED 22, thus is easily subjected to wavelength conversion by the phosphors 5, has a large amount of yellow light components, and becomes white light with low color temperature. Then these white rays of light are combined together and irradiated to outside of the light-emitting device 1b. Therefore, also in the present embodiment, as is the case with the second embodiment, color unevenness hardly occurs and a uniform irradiation pattern can be provided.

Next, a light-emitting device according to a fourth embodiment will be described referring to Figs. 5 (a) and 5 (b). As shown in Fig. 5 (a), the light-emitting device 1c according to the present embodiment is configured such that intervals at which outer LEDs 22 are arranged on a board 3 are smaller than intervals at which inner LEDs 21 are arranged thereon. A shape of the wavelength conversion part 4 is not specifically limited and thus, for example, may collectively coat a plurality of solid light-emitting elements as shown in the first embodiment described above or may be formed by potting as shown in the second embodiment described above. Further, it may have different thickness for the inner LED 21 and the outer LED 22 as shown in the third embodiment described above. Other configuration is the same as that of the embodiments described above. Illustrated in the figure are only the plurality of solid light-emitting elements 2 mounted on the board 3.

Here, a reference example of the present embodiment is shown in Fig. 5 (b). A light-emitting device 1d in this reference example has a plurality of solid light-emitting elements 2 arranged on a board 3 at equal intervals. With this configuration, a larger number of rays of light of the inner LEDs 21 emanated towards outer periphery of the board 3 are superposed on each other than that of the outer LEDs 22. Thus, as shown in the figure, the luminous flux B emanated from the inner LEDs 21 is larger than that of luminous flux C emanated from the outer LEDs 22.

On the contrary, with the configuration of the present embodiment, increasing the number of outer LEDs 22 can make the luminous flux C emanated towards the outer periphery of the outer LEDs 22 equal to that of the luminous flux B emanated towards the outer periphery of the inner LEDs 21. That is, luminous flux B each of which is white light with low color temperature from the inner LED 21 is equal to luminous flux C each of which is white light with high color temperature from the outer LED 22. Therefore, light emanated towards outer periphery of the light-emitting device 1c is not biased to either of white light components with the high color temperature and white light components with the low color temperature, which can therefore further improve uniformity of an irradiation pattern of the light-emitting device 1c.

The present invention is not limited to the embodiments described above and thus various modifications can be made thereto within a range not departing from spirits of the present invention. For example, illustrated above as the solid light-emitting elements are those in which the outer LEDs 22 are arranged at position close to outermost periphery of the board 3, but they are not limited thereto as long as they are closer to the outer periphery than the solid light-emitting elements arranged at the position close to the center of the board 3.

### [Description of Reference Numerals]

- 1: Light-emitting device
- 2: Solid light-emitting element
- 21: Inner LED
- 22: Outer LED
- 3: Board
- 4: Wavelength conversion part
- 41: First wavelength conversion part
- 42: Second wavelength conversion part
- 5: Phosphor

## Claims

1. A light-emitting device comprising:
a plurality of solid light-emitting elements mounted on a board; and
a wavelength conversion part coating the solid light-emitting elements and including phosphors, wherein
the plurality of solid light-emitting elements include: solid light-emitting elements arranged at a position close to a center of the board; and solid light-emitting elements arranged at position close to outer periphery than the aforementioned solid light-emitting elements, and
the wavelength conversion part is configured such that proportion of the phosphors at a portion coating the solid light-emitting elements arranged at the position close to the outer periphery of the board is lower than proportion of the phosphors at other portions.

2. The light-emitting device according to claim 1, wherein
the wavelength conversion part is configured such that concentration of the phosphors at the portion coating the solid light-emitting elements arranged at the position close to the outer periphery of the board is lower than concentration of the phosphors at the other portions.

3. The light-emitting device according to claim 2, wherein
the wavelength conversion part is configured such that concentration of the phosphors at a portion coating outer peripheral side surfaces of the solid light-emitting elements arranged at the position close to the outer periphery of the board is lower than the concentration of the phosphors at the other portions.

4. The light-emitting device according to claim 1, wherein
the wavelength conversion part is configured such that thickness of the portion coating the solid light-emitting elements arranged at the position close to the outer periphery of the board is thinner than thickness of the other portions.

5. The light-emitting device according to claim 4, wherein
the wavelength conversion part is configured such that thickness of the portion coating the outer peripheral side surfaces of the solid light-emitting elements arranged at the position close to the outer periphery of the board is thinner than the thickness of the other portions.

6. The light-emitting device according to any one of claims 1 to 5,
wherein
an arrangement interval between the solid light-emitting elements arranged at the position close to the outer periphery of the board is smaller than an arrangement interval between the solid light-emitting elements arranged at the position close to the center.

7. An illumination fixture comprising the light-emitting device according to any one of claims 1 to 6.
